# EUROPEAN PATENT SPECIFICATION

(11) **EP 4 503 036 B1**
(45) Date of publication and mention of the grant of the patent: **18.02.2026**
(21) Application number: 23189172.2
(22) Date of filing: 02.08.2023
(51) Int. Cl.: G11C 19/28, H10D 44/45

(54) **A READ-OUT SCHEME FOR AN INTEGRATED 3D CHARGE-COUPLED DEVICE MEMORY**
AUSLESESCHEMA FÜR EINEN INTEGRIERTEN 3D LADUNGSTRANSFERSPEICHER
SCHÉMA DE LECTURE POUR UNE MÉMOIRE INTÉGRÉE À DISPOSITIF À COUPLAGE DE CHARGE 3D

(43) Date of publication of application: 05.02.2025
(73) Proprietor: Imec VZW, 3001 Leuven (BE)
(72) Inventor: Mahato, Swaraj Bandhu, 3012 Wilsele (BE); Rosmeulen, Maarten, 9000 Gent (BE); De Munck, Koen, 3210 Linden (BE)
(74) Representative: Roth, Sebastian

(56) References cited:
- US-A- 3 858 232
- US-A- 5 077 762

## Description

### TECHNICAL FIELD

The present disclosure relates to a charge-coupled device (CCD) memory. In particular, the disclosure provides an architecture and method of operation for a three-dimensional (3D) integrated CCD memory, which may be a storage class memory (SCM). The method of operation specifically provides a read-out scheme for the CCD memory.

### BACKGROUND

Today, data creation is skyrocketing, propelled by data-driven technologies. This has left the memory (or storage) pyramid in urgent need of transformation. In particular, the gap between low-cost storage memory and high-speed working memory has to be bridged. The gap results from a mismatch between the increasing need for computing growing amounts of data versus trends in the underlying memory technologies. The increasing demand and the approaching scaling "brick wall" of conventional dynamic random access memory (DRAM) has prompted the search for new types of memory.

For instance, various types of so-called storage class memory (SCM) have been proposed, but no completely satisfactory solution has emerged yet. The available alternatives for DRAM lack either scalability like phase change memory (PCM), or lack power efficiency like magnetic random access memory (MRAM), or lack cycling capability like low-latency NAND memory.

CCD-based SCM has emerged as a fundamentally new class of memory, and is considered a good candidate for bridging the memory gap, while having a significant cost advantage over DRAM. The CCDs lack the byte-addressability, which is conventionally required for RAM. One idea employed in this disclosure is to trade this byte-addressability for lower costs. However, a CCD-based memory array architecture is needed - along with efficient read, write, and refresh schemes - to realize the high memory cell densities desired.

US 3858232 A discloses information storage devices.

US 5077762 A discloses a charge transfer device having Metal-Insulator-Metal (MIM) structures and a method for driving the same.

### SUMMARY

In view of the above, this disclosure aims to provide an improved memory device based on a CCD, in particular, an improved SCM. An objective thereby is to provide a memory array architecture, which enables high memory cell densities. Another objective thereby is to provide an efficient read-out scheme for a CCD-based SCM.

These and other objectives are achieved by the solutions of this disclosure as provided in the independent claims. Advantageous implementations are described in the dependent claims.

The solutions of this disclosure are based on an integrated 3D memory array architecture, which - along with at least a corresponding read-out scheme - allows realizing a SCM with high memory cell density.

A first aspect of this disclosure provides an integrated 3D CCD memory comprising: a layer stack including a plurality of gate layers and spacer layers, which are alternatingly arranged one on the other along a first direction; a plurality of semiconductor-based channels extending in the stack, wherein the channels form, in combination with the gate layers and one or more gate dielectric layers, a plurality of strings of charge storage capacitors operable as a plurality of CCD registers, wherein an end of each CCD register is connected to a floating diffusion, wherein each of the one or more gate dielectric layers is arranged between one of the plurality of semiconductor-based channels and at least one of the plurality of gate layers; and a plurality of charge sensing circuits, wherein each charge sensing circuit is connected to the floating diffusion of at least one CCD register, and is configured to translate charge in the floating diffusion of the at least one CCD register into a voltage on an associated column line.

The charge storage capacitors may be connected in series to form the CCD registers. The charge storage capacitors may be MOS capacitors. The one or number of storage capacitors in the CCD register may be considered a memory cell of the CCD memory.

By integrating the CCD registers in a 3D arrangement - i.e., by building the stack of the gate layers and the spacer layers along the first direction, and by forming the channels in this stack, preferably aligned vertically along the first direction - a high density like in 3D NAND Flash can be achieved. Thus, the costs (per stored bit) may become low. The CCD memory of the first aspect can be used as SCM, under the premise that byte-addressability can be omitted. The CCD memory may provide high speeds, good reliability, nearly unlimited cycling, and low power consumption.

Moreover, the plurality of charge sensing circuits, which are respectively connected to the one or more floating diffusions of one or more CCD registers, allow the implementation of an efficient read-out scheme.

In an implementation of the 3D CCD memory, the charge sensing circuits are arranged in a two-dimensional (2D) array comprising multiple rows of charge sensing circuits and multiple columns of charge sensing circuits.

Thus, a high density of charge sensing circuits can be realized for reading out a high-density array of CCD registers. The CCD registers may be likewise arranged in a 2D array comprising multiple rows of CCD registers and multiple columns of CCD registers. The arrays of the charge sensing circuits and the CCD registers may correspond.

In an implementation of the 3D CCD memory, each column of charge sensing circuits is connected to one column line of a plurality of column lines.

In an implementation of the 3D CCD memory, each row of charge sensing circuits is connected to one row select line of a plurality of row select lines; and each charge sensing circuit is configured to translate the charge in the floating diffusion into the voltage on the associated column line, when the row select line is activated.

This allows operating a row of charge sensing circuits at once, to read-out a corresponding row of CCD registers, wherein the charge output by different CCD registers is translated to voltages on different column lines.

In an implementation of the 3D CCD memory, each charge sensing circuit comprises a first transistor, an operation of which is controlled by the charge in the floating diffusion connected to the charge sensing circuit; and the first transistor is configured as a source-follower transistor that is connected with its drain to a supply voltage.

The source-follower transistor is configured to translate charge in the floating diffusion, which controls a gate of the first transistor, to a voltage at the source of the first transistor, which may be provided further towards the column line.

In an implementation of the 3D CCD memory, each charge sensing circuit further comprises a second transistor, an operation of which is controlled by the row select line connected to the charge sensing circuit; and the second transistor is configured to connect the source of the first transistor to the associated column line, in order to enable the charge sensing circuit to translate the charge in the floating diffusion into the voltage on the associated column line, when the row select line is activated.

Thus, the voltage at the source of the first transistor may be translated by the second transistor to the voltage on the column line.

In an implementation of the 3D CCD memory, each row of charge sensing circuits is further connected to one reset line of a plurality of reset lines; and each charge sensing circuit is configured to cause a reset of the floating diffusion to which it is connected, when the reset line is activated.

This leads to more accurate read-out results, and also enables the implementation of a scheme called correlated double sampling (CDS).

In an implementation of the 3D CCD memory, each charge sensing circuit comprises a third transistor, an operation of which is controlled by the reset line connected to the charge sensing circuit; and the third transistor is configured to enable the reset of the floating diffusion, when the reset line is activated.

In an implementation of the 3D CCD memory, each charge sensing circuit is connected to two or more of the CCD registers, and is configured to translate charge in the floating diffusion of any one or both of the two or more CCD registers into a voltage on the associated charge line.

This allows sharing of charge sensing circuits by multiple CCD registers, and may lead to a reduction of the footprint of the CCD memory.

In an implementation of the 3D CCD memory, each CCD register comprises one or more output transfer-gates defined in the one or more gate layers that are closest to the end of the CCD register; and the one or more output transfer gates are configured to allow charge to move from the string of charge storage capacitors of the CCD register to the floating diffusion of the CCD register.

In an implementation of the 3D CCD memory, each CCD register further comprises one or more buffer gates defined in one or more gate layers and arranged between the string of charge storage capacitors and the one or more output transfer-gates; and the one or more buffer gates are configured to aggregate charge from the string of charge storage capacitors before the aggregated charge is allowed to move to the floating diffusion.

The buffer gates allow charge aggregation for a more robust operation of the CCD memory.

In an implementation of the 3D CCD memory, each CCD register is associated with a set of word lines, which are operable to transport charge along the string of charge storage transistors towards the end of the CCD register; and/or the one or more buffer gates and the one or more output transfer gates are respectively operable by a subset of word lines from the set of word lines associated with the CCD register.

A second aspect of this disclosure provides a method of operating the 3D CCD memory of the first aspect or any implementation thereof, wherein for reading out at least one CCD register of the 3D CCD memory, the method comprises: moving charge from the string of charge storage capacitors of the at least one CCD register to the floating diffusion of the at least one CCD register; and controlling a charge sensing circuit connected to the floating diffusion of the at least one CCD register to translate a charge in the floating diffusion into a first voltage on a column line associated with the at least one CCD register.

In an implementation of the method, before moving the charge to the floating diffusion, the method comprises activating the reset line to which the charge sensing circuit is connected.

In an implementation, the method further comprises, after activating the reset line: activating the row select line to which the charge sensing circuit is connected; determining a second voltage on the associated column line; then moving the charge to the floating diffusion; determining the first voltage on the associated column line; and subtracting the first voltage from the second voltage.

This implements the above-mentioned CDS scheme and helps to reduce noise.

In an implementation, the method comprises operating the charge sensing circuits row by row by subsequently activating the row select lines, in order to read out the plurality of CCD registers.

The method of the second aspect may achieve similar advantages as the memory of the first aspect, and may be extended by respective implementations as described above for the memory of the first aspect.

### BRIEF DESCRIPTION OF THE DRAWINGS

The above described aspects and implementations are explained in the following description of embodiments with respect to the enclosed drawings:
- FIG. 1: shows an example of an integrated 3D CCD memory according to this disclosure.
- FIG. 2: shows an example of a semiconductor-based channel of an integrated 3D CCD memory according to this disclosure.
- FIG. 3: shows an array of semiconductor-based channel and a corresponding array of charge sensing circuits of an integrated 3D CCD memory according to this disclosure.
- FIG. 4: shows an example of a charge sensing circuit that is connected to the floating diffusion of a semiconductor-based channel of an integrated 3D CCD memory according to this disclosure.
- FIG. 5: shows an example of an array of charge sensing circuits of a 3D CCD memory according to this disclosure.
- FIG. 6: shows an example of an array of charge sensing circuits of a 3D CCD memory according to this disclosure, wherein charge sensing circuits are shared between two CCD registers.
- FIG. 7: shows a method of operating a 3D CCD memory according to this disclosure, in particular, for reading out at least one CCD register.

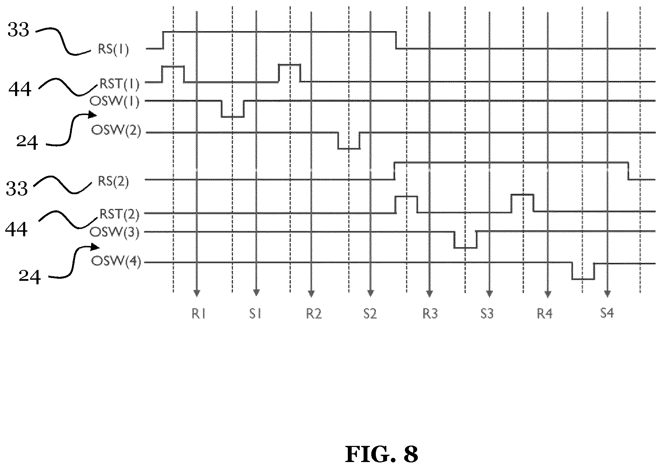

- FIG. 8: shows a timing diagram of a two-CCD-register shared read operation of an integrated 3D CCD memory according to this disclosure.

### DETAILED DESCRIPTION OF EMBODIMENTS

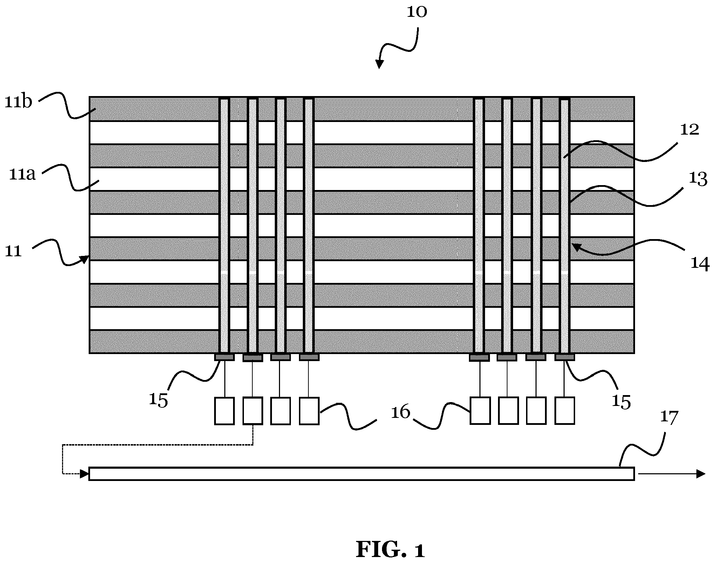

FIG. 1 shows an integrated 3D CCD memory 10 according to this disclosure. The CCD memory 10 can be an SCM, for instance, a block-addressable SCM. The CCD memory 10 may be used as a DRAM replacement in some of its use cases, or as an improved substitute for various other types of SCM. For instance, the CCD memory 10 of this disclosure may provide better scalability than a PCM, and/or may have a better power efficiency than a MRAM, and/or may have a better cycling capability than low-latency NAND memory.

The CCD memory 10 comprises a layer stack 11 including a plurality of gate layers 11a and spacer layers 11b, which are alternatingly arranged one on the other along a first direction (which corresponds to the vertical direction in FIG. 1). The layer stack 11 may either start with a gate layer 11a or a spacer layer 11b (as bottommost layer), for instance, on a substrate. The layer stack 11 may likewise end with a gate layer 11a or a spacer layer 11b (as topmost layer), and the illustrated stack 11 of FIG. 1 is just an example.

The CCD memory 10 further comprises a plurality of semiconductor-based channels 12 extending in the stack 11. These channels 12 form, in combination with the gate layers 11a and with one or more gate dielectric layers 13, a plurality of strings of charge storage capacitors. Each of the one or more gate dielectric layers 13 is arranged between one of the plurality of semiconductor-based channels 12 and at least one of the plurality of gate layers 11a. These charge storage capacitors are operable as a plurality of CCD registers 14. Notably, each gate layer 11a may surround one or more of the semiconductor-based channels 12. An end of each CCD register 14 comprises, or is connected to, a floating diffusion 15.

The semiconductor-based channels 12 may respectively be made of a semiconductor oxide material. For instance, the semiconductor oxide material may comprise at least one of indium gallium zinc oxide (IGZO), indium tin oxide (ITO), and indium zinc oxide (IZO), or another wide-bandgap oxide semiconductor. Such wide-bandgap oxide semiconductors allow achieving an increased retention time of the CCD memory 10. The semiconductor-based channels 12 may also be made of a silicon-based semiconductor material or of a III-V semiconductor material.

In order to fabricate the plurality of channels 12, a plurality of holes may formed through the entire layer stack 11 (after the stack 11 has been grown, for example), and may then be filled or plugged with the semiconductor-based material, for example, with the semiconductor oxide material like IGZO, along with the one or more dielectric layers 13. The dielectric layers 13 are each arranged between one of the semiconductor-based channels 12 and at least one of the gate layers 11a. Thereby, the strings of charge storage capacitors connected together as a CCD register architecture are formed.

The semiconductor-based channels 12 may extend along the first direction and/or may extend perpendicular to the parallel surfaces of the gate layers 11a. The semiconductor-based channels 12 may be straight in the stack 11, or may have a bend in the stack 11, in particular, they could respectively have a U-shape. The semiconductor-based channels 12 may be full channels or macaroni-type channel.

The CCD memory 10 further comprises a plurality of charge sensing circuits 16. Each charge sensing circuit 16 is connected to the floating diffusion 15 of at least one CCD register 14. Each charge sensing circuit 16 is configured to translate charge in the floating diffusion 15 of the at least one CCD register 14, to which it is connected, into a voltage on an associated column line 17, i.e., a column line 17 that is associated with the charge sensing circuit 16 and the at least one CCD register 14, respectively.

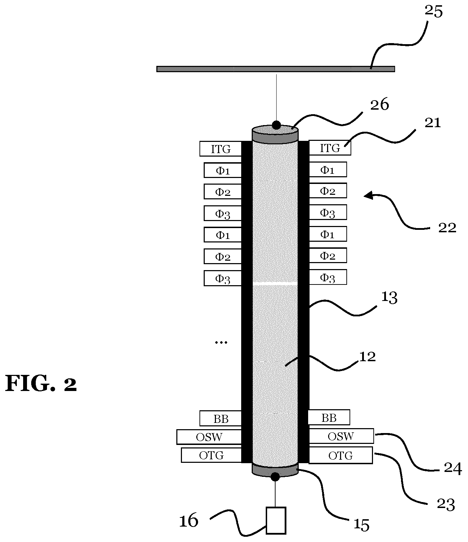

FIG. 2 shows an example of a semiconductor-based channel 12 of an integrated 3D CCD memory 10 according to this disclosure, for instance, as it may be used in the CCD memory 10 of FIG. 1. Same elements in FIG. 1 and FIG. 2 are labelled with the same reference signs. The semiconductor-based channel 12 of FIG. 2 allows realizing the 3D approach of the vertical CCD registers 14 with the horizontal gate layers 11a, as illustrated in FIG. 1 (where horizontal and vertical may denote two perpendicular directions). The channel 12 may be a macaroni-type channel, however, it could also be a full channel.

The gate layers 11a may be connected to and/or may be used to define a plurality of word lines 22 (also referred to as CCD gates). Each CCD register 14 of the CCD memory 10 is associated with a set of these word lines 22. The word lines 22 may be used to transport charge along the string of charge storage transistors towards the end of the CCD register 14. In particular, a first subset of the set of word lines 22 may also be referred to as phase lines (Φ1, Φ2, Φ3), and these phase line may be used to implement clocking, in order to move the charge. The word lines 22 of the first subset may be used to coordinate the operation of a CCD register 14 using a series of clocking phases e.g. Φ1, Φ2, and Φ3. The clocking phases may be applied to different word lines 22 of the first subset, which may be used to control the potential barriers within the CCD register 14 and thereby control the movement of charge along the CCD register 14.

Each CCD register 14 may further comprise one or more output transfer-gates 23. The one or more output transfer-gates 23 may be defined in the one or more gate layers 11a that are closest to the end of the CCD register 14. The one or more output transfer-gates 23 are operable (e.g., open or close) by a second subset of the set of word lines 22 associated with the CCD register 14. When operated to open, the one or more output transfer-gates 23 are configured to allow charge to move from the string of charge storage capacitors of the CCD register 14 to the floating diffusion 15 of the CCD register 14. From the floating diffusion 15 the charge may then be read by the connected charge sensing circuit 16. i.e., may be translated into a voltage on the associated column line 17.

Each CCD register 14 may further comprise one or more buffer gates 24. The one or more buffer gates 24 may be defined in one or more gate layers 11a and are arranged between the string of charge storage capacitors and the one or more output transfer-gates 23. The one or more buffer gates 24 may be separated from each other, for instance, they may be cut into a line pattern during the fabrication of the CCD memory 10. The buffer gates 24 can function like memory array row selectors. The one or more buffer gates 24 are operable by a third subset of the set of word lines 22 associated with the CCD register 14. The one or more buffer gates 24 are configured, when activated, to aggregate charge from the string of charge storage capacitors, before the aggregated charge is allowed to move to the floating diffusion 15 (by means of operating the output transfer-gates 23). From the floating diffusion 15 the aggregated charge may then be read by the connected charge sensing circuit 16, i.e., may be translated into a voltage on the associated column line 17.

The 3D CCD memory 10 may further comprises a plurality of input transfer-gates 21. The one or more input transfer-gates 21 may be defined in the one or more topmost gate layers 11, i.e., those that are farthest away from the end of the CCD register 14. The one or more input transfer-gates 21 are operable (e.g., open or close) by a fourth subset of the set of word lines 22 associated with the CCD register 14. At least one input transfer-gate 21 per CCD register 14 may be configured to enable a controlled access of the CCD register 14.

The 3D CCD memory 10 may further comprise a plurality of bit lines 25, wherein each bit line 25 may be associated with one or more of the CCD registers 14. The at least one input transfer-gate 21 per CCD register 14 may be operable to allow charge to be provided from an associated bit line 25 towards and into the CCD register 14. To this end, the bit line 25 may be connected to an input junction 26, which is again connected to the input transfer gate 21 of the CCD register 14.

The CCD registers 14 of the CCD memory 10 may be divided into blocks and sub-blocks. That is, the CCD memory 10 may comprise one or more blocks. Each bit line 25 may be connected to one CCD register 14 per sub-block, but may be connected to more than one CCD register 14 per block.

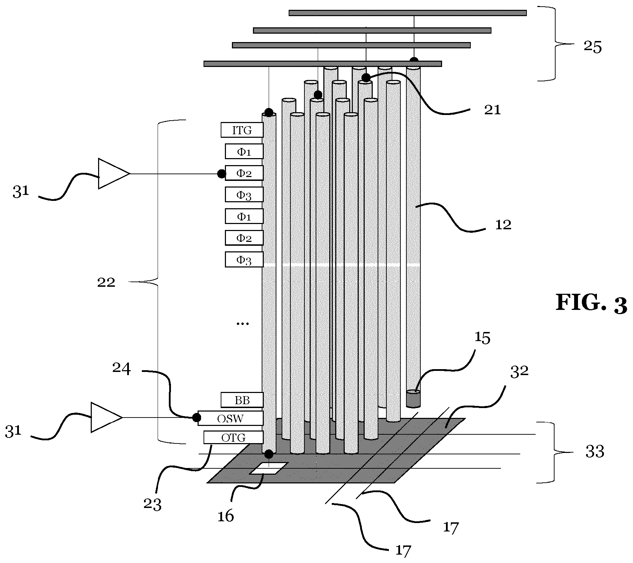

The charge sensing circuits 16 of the 3D CCD memory 10 may be arranged in a two-dimensional (2D) array 32, which comprises multiple rows of charge sensing circuits 16, and multiple columns of charge sensing circuits 16. For example, FIG. 3 shows in this respect an array of semiconductor-based channels 12 and a corresponding array 32 of charge sensing circuits 16 of an integrated 3D CCD memory according to this disclosure. Same elements in FIG. 3 and the previous figures are labelled with the same reference signs.

The multiple semiconductor-based channels 12 may all extend in parallel (as also shown in FIG. 1, and may each be associated with a set of word lines 22, which may be connected to word line drivers 31. The bit lines 25 may run perpendicular to the channels 12, and may be connected to the channels 12 as described above.

In the array 32 of charge sensing circuits 16, each charge sensing circuit 16 is connected to the floating diffusion 15 of one or more CCD registers 14. In a simple case, each charge sensing circuit 16 is connected to the floating diffusion 15 of exactly one CCD register 14. The floating diffusion 15 is formed at the end of the CCD register 14.

In the array 32 of charge sensing circuits 16, each column of the charge sensing circuits 16 is connected to one column line 17 of a plurality of column lines 17 of the CCD memory 10. Further, each row of charge sensing circuits 16 is connected to one row select line 33 of a plurality of row select lines 33 of the CCD memory 10. The row select lines 33 are operable to select the charge sensing circuits 16 of the corresponding rows. That means, each charge sensing circuit 16 is configured to translate charge into the voltage on the column line 17, with which it is associated, when the row select line 33 of the row is activated.

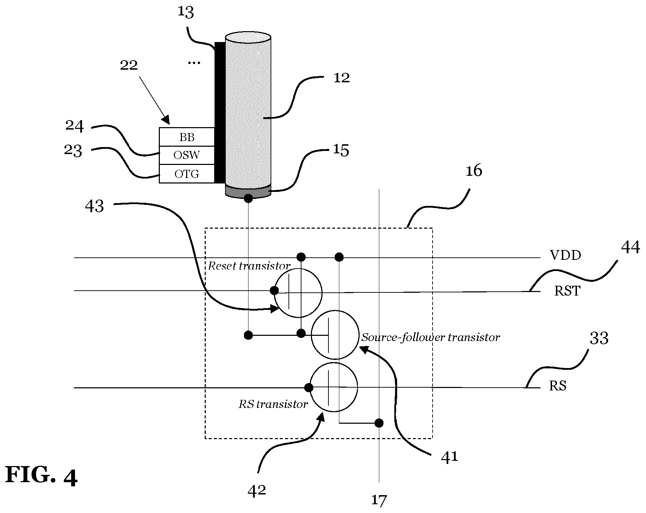

FIG. 4 shows an example of a charge sensing circuit 16, which is connected to the floating diffusion 15 of a semiconductor-based channel 12 of an integrated 3D CCD memory 10 according to this disclosure. The CCD register 14 formed based on the channel 12 is shown to have generally the word lines 22, specifically the buffer gate 24 and output transfer- gate 23.

The charge sensing circuit 16 comprises a first transistor 41 (also referred to as source-follower transistor), a second transistor 42 (also referred to as a row select (RS) transistor), and a third transistor 43 (also referred to as reset transistor). Further, the charge sensing circuit 16 is connected between the floating diffusion 15 of the CCD register 14 and the column line 17.

The first transistor 41 is configured as a source-follower transistor that is connected with its drain to a supply voltage (VDD), and with its source to the drain of the second transistor 42. The first transistor 41 is controlled by the charge in the floating diffusion 15, i.e., its gate is connected to the floating diffusion 15. The first transistor 41 is configured to translate the charge in the floating diffusion 15 of the at least one CCD register 14 into a voltage at its source. The second transistor 42 is controlled by the row select line 33 connected to the charge sensing circuit 16, i.e., its gate is connected to this row select line 33. The second transistor 42 is configured to connect the source of the first transistor 41 to the column line 17. To this end, the second transistor 42 is connected with its drain to the source of the first transistor 41, and with its source to the column line 17. That is, when the row select line 33 is activated, the second transistor 42 is configured to translate the voltage at the source of the first transistor 41, which depends on the charge in the floating diffusion 15, to a voltage on the column line 17.

The third transistor 43 is controlled by one of a plurality of reset lines 44 of the CCD memory 10, i.e., it is connected with its gate to the reset line 44. The third transistor 43 is further connected with its drain to VDD and with its source to the gate of the first transistor 41 and the floating diffusion 15. The third transistor 43 is configured to enable the reset of the floating diffusion 15, when the reset line 44 is activated. Resetting the floating diffusion 15 comprises clearing residual charge in the floating diffusion 15.

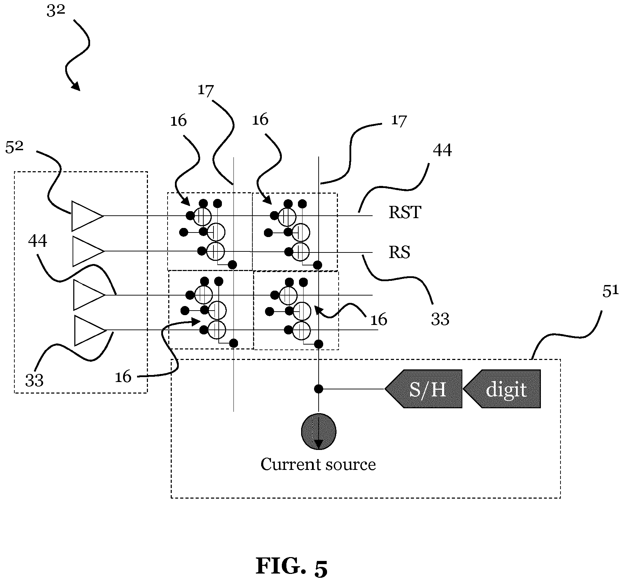

FIG. 5 shows an example of an array 32 of charge sensing circuits 16 of a CCD memory according to this disclosure. The array 32 of charge sensing circuits 16 includes the multiple charge sensing circuits 16, which are arranged in rows and columns, and are respectively connected to a row select line 33 per row of charge sensing circuits 16, to a reset line 44 per row of charge sensing circuits 16, and to a column line 17 per column of charge sensing circuits 16. The row select lines 33 and the reset lines 44 may run across the entire array 32 of charge sensing circuits 16. The internal connection lines, for instance, of the charge sensing circuit 16 to the floating diffusion 15 or between the three transistors, are associated only to the CCD register 14, to which the charge sensing circuit 16 is connected. The reset lines 44 and the row select lines 33 may be connected to row drivers 52, which are respectively configured to activate these lines 33, 44, for instance, by changing a voltage on the respective line 33, 44. The column lines 17 may be connected to a column read-out circuit 51 (including, for example, a current source, analog-digital-converter (ADC), sample-and-hold (S/H) circuit, digitizer circuit, or the like), as shown in FIG. 5.

The charge sensing circuits 16 in the array 32 may be made in a silicon substrate, for instance, on a silicon wafer. The three transistors 41, 42, 43 of each charge sensing circuit 16 may respectively be CMOS transistors. The transistors 41, 42, 43 have been described as being field effect transistors (FETs) having gate(s), source(s), and drain(s). However, the transistors 41, 42, 43 could also be bipolar junction transistors (BJTs) having base(s), collector(s), and emitter(s).

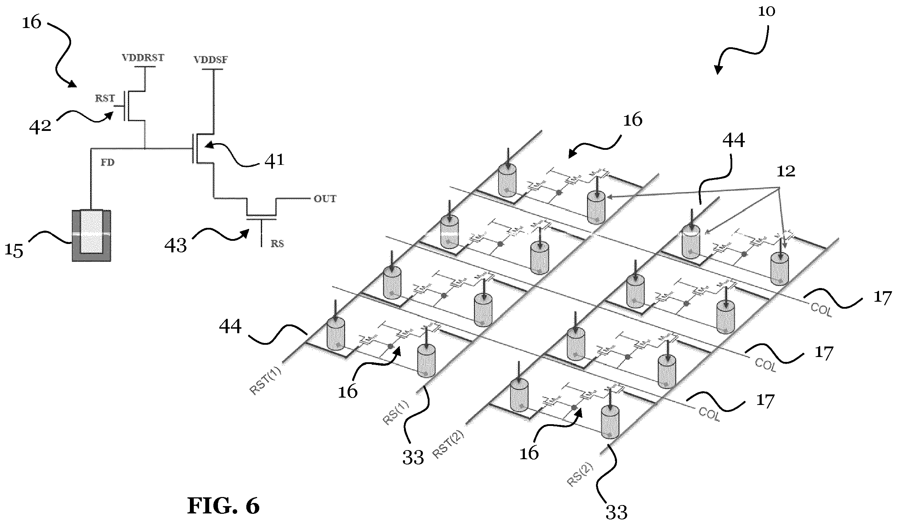

FIG. 6 shows an example of an array 32 of charge sensing circuits 16, wherein the charge sensing circuits 16 are shared between multiple floating diffusions 15, i.e., between multiple CCD registers 14. The concept thereby is that multiple adjacent CCD register 14 may provide charge to a shared charge sensing circuit 16. For instance, the shared charge sensing circuit 16 may then be configured to alternately translate the charge in the floating diffusions 15 of the different CCD registers 14 of the multiple CCD registers 14 to a respective voltage on the same column line 17. That is, one or more charge sensing circuits 16 may be connected, respectively, two or more of the CCD registers 14, and may translate charge in the floating diffusion 15 of any one or both of the two or more CCD registers 14 into a respective voltage on the associated column line 17. In FIG. 6, an example of a two-CCD-register shared architecture is shown, wherein only the read-out part is depicted.

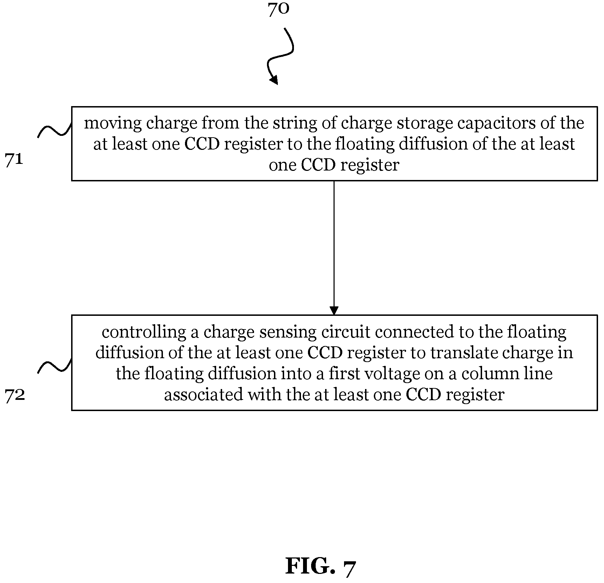

FIG. 7 shows a method 70 of operating the 3D CCD memory 10, in particular, a method 70 for performing a read operation on at least one CCD register 14 of the CCD memory 10. To this end, the method 70 generally comprises a step 71 of moving charge from the string of charge storage capacitors of the at least one CCD register 14 to the floating diffusion 15 of said at least one CCD register 14. Then the method 70 comprises a step 72 of controlling the charge sensing circuit 16 connected to the floating diffusion 15 of the at least one CCD register 14, in order to translate charge in the floating diffusion 15 into the voltage on the column line 17 associated with the at least one CCD register 14.

During a read operation of the entire array 32 of charge sensing circuits 16 of the CCD memory 10, charge(s) may be read out row-by-row. For this, at first the row select line 33 associated with a first row may be activated. This will turn on the second transistors 42 of all charge sensing circuits 16 in this first row. Then, the reset line 44 associated with the first row may be activated. This will reset the floating diffusions 15 of all CCD registers 14, to which the charge sensing circuits 16 of the first row are connected. Finally, for each CCD register 14 connected to a charge sensing circuit 16 of the first row, a charge (corresponding e.g., to a data bit) from the semiconductor-based channel 12 of the CCD register 14 is pushed out from the string of charge storage capacitors to the floating diffusion 15 (optionally aggregated by the buffer gate 24). This charge is then sensed as a voltage by the first (source-follower) transistor 41 of the charge sensing circuit 16. The same procedure can then be repeated for a second row, third row, and so on.

FIG. 7 shows in this respect a timing diagram of a two-CCD-register shared read operation in a CCD memory 10 according to this disclosure. This example uses the buffer gate 24. At first, a first row select line 33 (RS(1)) and a first reset line 44 (RST(1)) are activated. Then, the buffer gate 24 (OSW(1)) of the first CCD register 14 connected to the charge sensing circuit 16 is operated to provide (aggregated) charge to the floating diffusion 15, and to allow the charge sensing circuit 16 to translate it to a voltage on the column line 17. Then the first reset line 44 is activated again, in order to reset the floating diffusion 15. Then, the buffer gate 24 (OSW(2)) of the second CCD register 14 connected to the charge sensing circuit 16 is operated to provide (aggregated) charge to the floating diffusion 15, and to allow the charge sensing circuit 16 to translate it to another voltage on the column line 17. Then, the same procedure may be repeated with a second row select line 33 (RS(2)), a second reset line 44 (RST(2)), and buffer gates (OSW(3) and OSW(4)) of other CCD registers 14 that are connected to the charge sensing circuit 16 of the second row.

This disclosure also foresees a correlated double sampling (CDS) operation, which may be performed to subtract reset noise or charge from real charge corresponding to data. To this end, the floating diffusions 15 of a particular row will first be reset and then sampled. Subsequently, charge (data) for that particular row will be transferred to the floating diffusions 15 of the CCD registers 14 in the particular row and then sampled. By doing this, a reset value (second voltage) and a data value (first voltage) may be collected, in order to do subtraction (CDS) externally in a data processing path to cancel noise.

In particular, for the CDS operation, a particular row select line 33 to which a particular charge sensing circuit 16 is connected may be activated. Then the second voltage on the associated column line 17 may be determined. Then the charge may be moved to the floating diffusion 15 of the CCD register 14 connected to the charge sensing circuit 16. Then, the first voltage may be determined on the associated column line 17. Finally, the first voltage may be subtracted from the second voltage.

In summary, the 3D CCD memory 10 proposed in this disclosure facilitates the mentioned way of memory cell sensing. To reduce bit cost and increase chip density, a pitch of the CCD register 14 is preferably as small as possible, however, this may impose area limitation to fit the charge sensing circuit 16 under each CCD register 14. In this disclosure, thus also the concept of sharing floating diffusions 15 (or CCD registers 14) for a charge sensing circuit 16 is proposed.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. An integrated three-dimensional, 3D, charge-coupled device, CCD, memory (10) comprising:
a layer stack (11) including a plurality of gate layers (11a) and spacer layers (11b), which are alternatingly arranged one on the other along a first direction;
a plurality of semiconductor-based channels (12) extending in the stack (11), wherein the channels (12) form, in combination with the gate layers (11a) and one or more gate dielectric layers (13), a plurality of strings of charge storage capacitors operable as
a plurality of CCD registers (14), wherein an end of each CCD register (14) is connected to a floating diffusion (15), wherein each of the one or more gate dielectric layers (13) is arranged between one of the plurality of semiconductor-based channels (12) and at least one of the plurality of gate layers (11a); and
a plurality of charge sensing circuits (16), wherein each charge sensing circuit (16) is connected to the floating diffusion (15) of at least one CCD register (14), and is configured to translate charge in the floating diffusion (15) of the at least one CCD register (14) into a voltage on an associated column line (17).

2. The 3D CCD memory (10) of claim 1, wherein the charge sensing circuits (16) are arranged in a two-dimensional (2D) array (32) comprising multiple rows of charge sensing circuits (16) and multiple columns of charge sensing circuits (16).

3. The 3D CCD memory (10) of claim 2, wherein each column of charge sensing circuits (16) is connected to one column line (17) of a plurality of column lines (17).

4. The 3D CCD memory (10) of claim 2 or 3, wherein:
each row of charge sensing circuits (16) is connected to one row select line (33) of a plurality of row select lines (33); and
each charge sensing circuit (16) is configured to translate the charge in the floating diffusion (15) into the voltage on the associated column line (17), when the row select line (33) is activated.

5. The 3D CCD memory (10) of one of the claims 1 to 4, wherein:
each charge sensing circuit (16) comprises a first transistor (41), an operation of which is controlled by the charge in the floating diffusion (15) connected to the charge sensing circuit (16); and
the first transistor (41) is configured as a source-follower transistor that is connected with its drain to a supply voltage (VDD).

6. The 3D CCD memory (10) of claim 5, wherein:
each charge sensing circuit (16) further comprises a second transistor (42), an operation of which is controlled by the row select line (33) connected to the charge sensing circuit (16); and
the second transistor (42) is configured to connect the source of the first transistor (41) to the associated column line (17), in order to enable the charge sensing circuit (16) to translate the charge in the floating diffusion (15) into the voltage on the associated column line (17), when the row select line (33) is activated.

7. The 3D CCD memory (10) of one of the claims 2 to 6, wherein:
each row of charge sensing circuits (16) is further connected to one reset line (44) of a plurality of reset lines (44); and
each charge sensing circuit (16) is configured to cause a reset of the floating diffusion (15) to which it is connected, when the reset line (44) is activated.

8. The 3D CCD memory (10) of one of the claims 2 to 7, wherein:
each charge sensing circuit (16) comprises a third transistor (43), an operation of which is controlled by the reset line (44) connected to the charge sensing circuit (16); and
the third transistor (43) is configured to enable the reset of the floating diffusion (15), when the reset line (44) is activated.

9. The 3D CCD memory (10) of one of the claims 1 to 8, wherein each charge sensing circuit (16) is connected to two or more of the CCD registers (14), and is configured to translate charge in the floating diffusion (15) of any one or both of the two or more CCD registers (14) into a voltage on the associated column line (17).

10. The 3D CCD memory (10) of one of the claims 1 to 9, wherein:
each CCD register (14) comprises one or more output transfer-gates (23) defined in the one or more gate layers (11a) that are closest to the end of the CCD register (14); and
the one or more output transfer-gates (23) are configured to allow charge to move from the string of charge storage capacitors of the CCD register (14) to the floating diffusion (15) of the CCD register (14).

11. The 3D CCD memory device (10) of claim 10, wherein:
each CCD register (14) further comprises one or more buffer gates (24) defined in one or more gate layers (11a) and arranged between the string of charge storage capacitors and the one or more output transfer-gates (23); and
the one or more buffer gates (24) are configured to aggregate charge from the string of charge storage capacitors before the aggregated charge is allowed to move to the floating diffusion (15).

12. The 3D CCD memory (10) of one of the claims 1 to 11, wherein:
each CCD register (14) is associated with a set of word lines (22), which are operable to transport charge along the string of charge storage transistors towards the end of the CCD register (14); and/or
the one or more output transfer-gates (23) and the one or more buffer gates (24) are respectively operable by a subset of word lines (22) from the set of word lines (22) associated with the CCD register (14).

13. A method (70) of operating the 3D CCD memory (10) of one of the claims 1 to 12, wherein for reading out at least one CCD register (14) of the 3D CCD memory (10), the method (70) comprises:
moving (71) charge from the string of charge storage capacitors of the at least one CCD register (14) to the floating diffusion (15) of the at least one CCD register (14); and
controlling (72) a charge sensing circuit (16) connected to the floating diffusion (15) of the at least one CCD register (14) to translate charge in the floating diffusion (15) into a first voltage on a column line (17) associated with the at least one CCD register (14).

14. The method (70) of claim 13, wherein before moving (71) the charge to the floating diffusion (15), the method (70) comprises activating the reset line (44) to which the charge sensing circuit (16) is connected.

15. The method (70) of claim 14, wherein the method (70) further comprises, after activating the reset line (44):
activating the row select line (33) to which the charge sensing circuit (16) is connected;
determining a second voltage on the associated column line (17);
then moving the charge to the floating diffusion (15);
determining the first voltage on the associated column line (17); and
subtracting the first voltage from the second voltage.

16. The method (70) of one of the claims 13 to 15, wherein the method (70) comprises operating the charge sensing circuits (16) row by row by subsequently activating the row select lines (33), in order to read out the plurality of CCD registers (14).

## Patentansprüche

1. Integrierter dreidimensionaler, 3D-CCD-Speicher (10), der Folgendes umfasst:
einen Schichtstapel (11), der eine Mehrzahl von Gate-Schichten (11a) und Abstandshalterschichten (11b) beinhaltet, die alternierend entlang einer ersten Richtung aufeinander angeordnet sind;
eine Mehrzahl von halbleiterbasierten Kanälen (12), die sich in dem Stapel (11) erstrecken, wobei die Kanäle (12) in Kombination mit den Gate-Schichten (11a) und einer oder mehreren Gate-Dielektrikum-Schichten (13) eine Mehrzahl von Ketten von Ladungsspeicherungskondensatoren bilden, die betreibbar sind als
eine Mehrzahl von CCD-Registern (14), wobei ein Ende jedes CCD-Registers (14) mit einer Floating-Diffusion (15) verbunden ist, wobei jede der einen oder mehreren Gate-Dielektrikum-Schichten (13) zwischen einem der Mehrzahl von halbleiterbasierten Kanälen (12) und mindestens einer der Mehrzahl von Gate-Schichten (11a) angeordnet ist; und
eine Mehrzahl von Ladungserfassungsschaltungen (16), wobei jede Ladungserfassungsschaltung (16) mit der Floating-Diffusion (15) mindestens eines CCD-Registers (14) verbunden ist und dazu ausgelegt ist, eine Ladung in der Floating-Diffusion (15) des mindestens einen CCD-Registers (14) in eine Spannung auf einer assoziierten Spaltenleitung (17) zu übersetzen.

2. 3D-CCD-Speicher (10) nach Anspruch 1, wobei die Ladungserfassungsschaltungen (16) in einem zweidimensionalen (2D) Array (32) angeordnet sind, das mehrere Reihen von Ladungserfassungsschaltungen (16) und mehrere Spalten von Ladungserfassungsschaltungen (16) umfasst.

3. 3D-CCD-Speicher (10) nach Anspruch 2, wobei jede Spalte von Ladungserfassungsschaltungen (16) mit einer Spaltenleitung (17) einer Mehrzahl von Spaltenleitungen (17) verbunden ist.

4. 3D-CCD-Speicher (10) nach Anspruch 2 oder 3, wobei:
jede Reihe von Ladungserfassungsschaltungen (16) mit einer Zeilenauswahlleitung (33) einer Mehrzahl von Zeilenauswahlleitungen (33) verbunden ist; und
jede Ladungserfassungsschaltung (16) dazu ausgelegt ist, die Ladung in der Floating-Diffusion (15) in die Spannung auf der assoziierten Spaltenleitung (17) zu übersetzen, wenn die Zeilenauswahlleitung (33) aktiviert ist.

5. 3D-CCD-Speicher (10) nach einem der Ansprüche 1 bis 4, wobei:
jede Ladungserfassungsschaltung (16) einen ersten Transistor (41) umfasst, dessen Betrieb durch die Ladung in der Floating-Diffusion (15) gesteuert wird, die mit der Ladungserfassungsschaltung (16) verbunden ist; und
der erste Transistor (41) als ein Source-Folger-Transistor ausgelegt ist, der mit seinem Drain mit einer Versorgungsspannung (VDD) verbunden ist.

6. 3D-CCD-Speicher (10) nach Anspruch 5, wobei:
jede Ladungserfassungsschaltung (16) ferner einen zweiten Transistor (42) umfasst, dessen Betrieb durch die Zeilenauswahlleitung (33) gesteuert wird, die mit der Ladungserfassungsschaltung (16) verbunden ist; und
der zweite Transistor (42) dazu ausgelegt ist, die Source des ersten Transistors (41) mit der assoziierten Spaltenleitung (17) zu verbinden, um der Ladungserfassungsschaltung (16) zu ermöglichen, die Ladung in der Floating-Diffusion (15) in die Spannung auf der assoziierten Spaltenleitung (17) zu übersetzen, wenn die Zeilenauswahlleitung (33) aktiviert ist.

7. 3D-CCD-Speicher (10) nach einem der Ansprüche 2 bis 6, wobei:
jede Reihe von Ladungserfassungsschaltungen (16) ferner mit einer Rücksetzleitung (44) der Mehrzahl von Rücksetzleitungen (44) verbunden ist; und
jede Ladungserfassungsschaltung (16) dazu ausgelegt ist, ein Zurücksetzen der Floating-Diffusion (15), mit der sie verbunden ist, zu bewirken, wenn die Rücksetzleitung (44) aktiviert ist.

8. 3D-CCD-Speicher (10) nach einem der Ansprüche 2 bis 7, wobei:
jede Ladungserfassungsschaltung (16) einen dritten Transistor (43) umfasst, dessen Betrieb durch die Rücksetzleitung (44) gesteuert wird, die mit der Ladungserfassungsschaltung (16) verbunden ist; und
der dritte Transistor (43) dazu ausgelegt ist, das Zurücksetzen der Floating-Diffusion (15) zu aktivieren, wenn die Rücksetzleitung (44) aktiviert ist.

9. 3D-CCD-Speicher (10) nach einem der Ansprüche 1 bis 8, wobei jede Ladungserfassungsschaltung (16) mit zwei oder mehr der CCD-Register (14) verbunden ist und dazu ausgelegt ist, eine Ladung in der Floating-Diffusion (15) eines oder beider der zwei oder mehr CCD-Register (14) in eine Spannung auf der assoziierten Spaltenleitung (17) zu übersetzen.

10. 3D-CCD-Speicher (10) nach einem der Ansprüche 1 bis 9, wobei:
jedes CCD-Register (14) ein oder mehrere Ausgangstransfergatter (23) umfasst, die in der einen oder den mehreren Gate-Schichten (11a) definiert sind, die dem Ende des CCD-Registers (14) am nächsten sind; und das eine oder die mehreren Ausgangstransfergatter (23) dazu ausgelegt sind, zu ermöglichen, dass sich eine Ladung von der Kette von Ladungsspeicherungskondensatoren des CCD-Registers (14) zu der Floating-Diffusion (15) des CCD-Registers (14) bewegt.

11. 3D-CCD-Speichervorrichtung (10) nach Anspruch 10, wobei:
jedes CCD-Register (14) ferner ein oder mehrere Puffergatter (24) umfasst, die in einer oder mehreren Gate-Schichten (11a) definiert und zwischen der Kette von Ladungsspeicherungskondensatoren und dem einen oder mehreren Ausgangstransfergattern (23) angeordnet sind; und
das eine oder die mehreren Puffergatter (24) dazu ausgelegt sind, eine Ladung aus der Kette von Ladungsspeicherungskondensatoren zu aggregieren, bevor die aggregierte Ladung sich zu der Floating-Diffusion (15) bewegen darf.

12. 3D-CCD-Speicher (10) nach einem der Ansprüche 1 bis 11, wobei:
jedes CCD-Register (14) mit einem Satz von Wortleitungen (22) assoziiert ist, die betreibbar sind, um Ladung entlang der Kette von Ladungsspeichertransistoren zum Ende des CCD-Registers (14) hin zu transportieren; und/oder
das eine oder mehrere Ausgangstransfergatter (23) und das eine oder mehrere Puffergatter (24) jeweils durch eine Teilmenge von Wortleitungen (22) aus dem Satz von Wortleitungen (22) betreibbar sind, die mit dem CCD-Register (14) assoziiert sind.

13. Verfahren (70) zum Betreiben des 3D-CCD-Speichers (10) nach einem der Ansprüche 1 bis 12, wobei zum Auslesen mindestens eines CCD-Registers (14) des 3D-CCD-Speichers (10) das Verfahren (70) Folgendes umfasst:
Bewegen (71) einer Ladung von der Kette von Ladungsspeicherungskondensatoren des mindestens einen CCD-Registers (14) zu der Floating-Diffusion (15) des mindestens einen CCD-Registers (14); und
Steuern (72) einer Ladungserfassungsschaltung (16), die mit der Floating-Diffusion (15) des mindestens einen CCD-Registers (14) verbunden ist, um eine Ladung in der Floating-Diffusion (15) in eine erste Spannung auf einer Spaltenleitung (17) zu übersetzen, die mit dem mindestens einen CCD-Register (14) assoziiert ist.

14. Verfahren (70) nach Anspruch 13, wobei das Verfahren (70) vor dem Bewegen (71) der Ladung zu der Floating-Diffusion (15) das Aktivieren der Rücksetzleitung (44) umfasst, mit der die Ladungserfassungsschaltung (16) verbunden ist.

15. Verfahren (70) nach Anspruch 14, wobei das Verfahren (70) ferner nach dem Aktivieren der Rücksetzleitung (44) Folgendes umfasst:
Aktivieren der Zeilenauswahlleitung (33), mit der die Ladungserfassungsschaltung (16) verbunden ist;
Bestimmen einer zweiten Spannung auf der assoziierten Spaltenleitung (17);
dann Bewegen der Ladung zu der Floating-Diffusion (15);
Bestimmen der ersten Spannung auf der assoziierten Spaltenleitung (17); und
Subtrahieren der ersten Spannung von der zweiten Spannung.

16. Verfahren (70) nach einem der Ansprüche 13 bis 15, wobei das Verfahren (70) ein zeilenweises Betreiben der Ladungserfassungsschaltungen (16) durch anschließendes Aktivieren der Zeilenauswahlleitungen (33) umfasst, um die Mehrzahl von CCD-Registern (14) auszulesen.

## Revendications

1. Mémoire tridimensionnelle, 3D, intégrée à base de dispositif à transfert de charge, CCD, (10), comprenant :
un empilement (11) de couches comportant une pluralité de couches de grille (11a) et de couches d'espacement (11b), disposées en alternance les unes sur les autres selon une première direction ;
une pluralité de canaux à base de semi-conducteur (12) s'étendant dans l'empilement (11), les canaux (12) formant, en combinaison avec les couches de grille (11a) et une ou plusieurs couches diélectriques de grille (13), une pluralité de chaînes de condensateurs de stockage de charge utilisables comme
une pluralité de registres CCD (14), une extrémité de chaque registre CCD (14) étant connectée à une diffusion flottante (15), chacune de la ou des couches diélectriques de grille (13) étant disposée entre l'un de la pluralité de canaux à base de semi-conducteur (12) et au moins l'une de la pluralité de couches de grille (11a) ; et
une pluralité de circuits de détection de charge (16), chaque circuit de détection de charge (16) étant connecté à la diffusion flottante (15) d'au moins un registre CCD (14), et étant configuré pour traduire la charge dans la diffusion flottante (15) de l'au moins un registre CCD (14) en une tension sur une ligne de colonne (17) associée.

2. Mémoire 3D à base de CCD (10) selon la revendication 1, dans laquelle les circuits de détection de charge (16) sont agencés dans un réseau bidimensionnel (2D) (32) comprenant de multiples rangées de circuits de détection de charge (16) et de multiples colonnes de circuits de détection de charge (16).

3. Mémoire 3D à base de CCD (10) selon la revendication 2, dans laquelle chaque colonne de circuits de détection de charge (16) est connectée à une ligne de colonne (17) d'une pluralité de lignes de colonne (17).

4. Mémoire 3D à base de CCD (10) selon la revendication 2 ou 3, dans laquelle :
chaque rangée de circuits de détection de charge (16) est connectée à une ligne de sélection de rangée (33) d'une pluralité de lignes de sélection de rangée (33) ; et
chaque circuit de détection de charge (16) est configuré pour traduire la charge dans la diffusion flottante (15) en la tension sur la ligne de colonne associée (17), lorsque la ligne de sélection de rangée (33) est activée.

5. Mémoire 3D à base de CCD (10) selon l'une des revendications 1 à 4, dans laquelle :
chaque circuit de détection de charge (16) comprend un premier transistor (41) dont le fonctionnement est commandé par la charge dans la diffusion flottante (15) connectée au circuit de détection de charge (16) ; et
le premier transistor (41) est configuré comme un transistor monté en source suiveuse, connecté par son drain à une tension d'alimentation (VDD).

6. Mémoire 3D à base de CCD (10) selon la revendication 5, dans laquelle :
chaque circuit de détection de charge (16) comprend en outre un deuxième transistor (42) dont le fonctionnement est commandé par la ligne de sélection de rangée (33) connectée au circuit de détection de charge (16) ; et
le deuxième transistor (42) est configuré pour connecter la source du premier transistor (41) à la ligne de colonne (17) associée, afin de permettre au circuit de détection de charge (16) de traduire la charge dans la diffusion flottante (15) en la tension sur la ligne de colonne (17) associée, lorsque la ligne de sélection de rangée (33) est activée.

7. Mémoire 3D à base de CCD (10) selon l'une des revendications 2 à 6, dans laquelle :
chaque rangée de circuits de détection de charge (16) est connectée en outre à une ligne de réinitialisation (44) d'une pluralité de lignes de réinitialisation (44) ; et
chaque circuit de détection de charge (16) est configuré pour provoquer une réinitialisation de la diffusion flottante (15) à laquelle il est connecté, lorsque la ligne de réinitialisation (44) est activée.

8. Mémoire 3D à base de CCD (10) selon l'une des revendications 2 à 7, dans laquelle :
chaque circuit de détection de charge (16) comprend un troisième transistor (43) dont le fonctionnement est commandé par la ligne de réinitialisation (44) connectée au circuit de détection de charge (16) ; et
le troisième transistor (43) est configuré pour permettre la réinitialisation de la diffusion flottante (15), lorsque la ligne de réinitialisation (44) est activée.

9. Mémoire 3D à base de CCD (10) selon l'une des revendications 1 à 8, dans laquelle chaque circuit de détection de charge (16) est connecté à au moins deux des registres CCD (14), et est configuré pour traduire la charge dans la diffusion flottante (15) de l'un et/ou l'autre des au moins deux registres CCD (14) en une tension sur la ligne de colonne (17) associée.

10. Mémoire 3D à base de CCD (10) selon l'une des revendications 1 à 9, dans laquelle :
chaque registre CCD (14) comprend une ou plusieurs grilles de transfert de sortie (23) définies dans la ou les couches de grille (11a) les plus proches de l'extrémité du registre CCD (14) ; et
la ou les grilles de transfert de sortie (23) sont configurées pour permettre à la charge de se déplacer de la chaîne de condensateurs de stockage de charge du registre CCD (14) vers la diffusion flottante (15) du registre CCD (14).

11. Dispositif de mémoire 3D à base de CCD (10) selon la revendication 10, dans lequel :
chaque registre CCD (14) comprend en outre une ou plusieurs grilles tampons (24) définies dans une ou plusieurs couches de grille (11a) et disposées entre la chaîne de condensateurs de stockage de charge et la ou les grilles de transfert de sortie (23) ; et
la ou les grilles tampons (24) sont configurées pour agréger la charge provenant de la chaîne de condensateurs de stockage de charge avant que la charge agrégée ne puisse se déplacer vers la diffusion flottante (15).

12. Mémoire 3D à base de CCD (10) selon l'une des revendications 1 à 11, dans laquelle :
chaque registre CCD (14) est associé à un ensemble de lignes de mot (22), lesquelles sont utilisables pour transporter la charge le long de la chaîne de transistors de stockage de charge vers l'extrémité du registre CCD (14) ; et/ou
la ou les grilles de transfert de sortie (23) et la ou les grilles tampons (24) sont respectivement utilisables par un sous-ensemble de lignes de mot (22) issu de l'ensemble de lignes de mot (22) associé au registre CCD (14).

13. Procédé (70) de fonctionnement de la mémoire 3D à base de CCD (10) selon l'une des revendications 1 à 12, le procédé (70) comprenant, pour la lecture d'au moins un registre CCD (14) de la mémoire 3D à base de CCD (10) :
le déplacement (71) d'une charge depuis la chaîne de condensateurs de stockage de charge de l'au moins un registre CCD (14) vers la diffusion flottante (15) de l'au moins un registre CCD (14) ; et
la commande (72) d'un circuit de détection de charge (16) connecté à la diffusion flottante (15) de l'au moins un registre CCD (14) afin de traduire la charge dans la diffusion flottante (15) en une première tension sur une ligne de colonne (17) associée à l'au moins un registre CCD (14).

14. Procédé (70) selon la revendication 13, le procédé (70) comprenant, avant le déplacement (71) de la charge vers la diffusion flottante (15), l'activation de la ligne de réinitialisation (44) à laquelle le circuit de détection de charge (16) est connecté.

15. Procédé (70) selon la revendication 14, le procédé (70) comprenant en outre, après l'activation de la ligne de réinitialisation (44) :
l'activation de la ligne de sélection de rangée (33) à laquelle le circuit de détection de charge (16) est connecté ;
la détermination d'une deuxième tension sur la ligne de colonne (17) associée ;
puis le déplacement de la charge vers la diffusion flottante (15) ;
la détermination de la première tension sur la ligne de colonne (17) associée, et
la soustraction de la première tension à la deuxième tension.

16. Procédé (70) selon l'une quelconque des revendications 13 à 15, le procédé (70) comprenant le fonctionnement des circuits de détection de charge (16) rangée par rangée par activation consécutive des lignes de sélection de rangée (33), afin de lire la pluralité de registres CCD (14).
